# EUROPÄISCHE PATENTSCHRIFT

(11) **EP 1 423 574 B1**
(45) Veröffentlichungstag und Bekanntmachung des Hinweises auf die Patenterteilung: **30.03.2005**
(21) Anmeldenummer: 02774302.0
(22) Anmeldetag: 03.09.2002
(51) Int. Cl.: E04B 1/92, H05K 9/00, H01Q 1/52, H01Q 17/00, E04D 11/00

(54) **HF-REDUZIERENDE DACHBEGRÜNUNG**
HF-REDUCING GREEN ROOFING
TOIT AGREMENTE DE PLANTES A REDUCTION DE HF

(30) Priorität: 05.09.2001 DE 10143655
(43) Veröffentlichungstag der Anmeldung: 02.06.2004
(73) Patentinhaber: Behrens, Wolfgang, D-27243 Gross Ippener (DE)
(72) Erfinder: Behrens, Wolfgang, D-27243 Gross Ippener (DE)
(74) Vertreter: Thömen, Uwe, Dipl.-Ing.
(86) Internationale Anmeldenummer: PCT/DE2002/003267
(87) Internationale Veröffentlichungsnummer: WO 2003/021055

(56) Entgegenhaltungen:
- EP-A- 1 096 077
- DE-A- 19 705 180
- UNIVERSITÄT KASSEL: "Gründächer und Lehmgewölbe bieten idealen Schutz gegen elektromagnetische Wellen" PRESSEMITTEILING 60/01 JUNI 2001, [Online] Juni 2001 (2001-06), XP002226377 Gefunden im Internet: <URL:http://www.uni-kassel.de/fb12/fachgeb iete/feb/f_proj/hf_d.htm> [gefunden am 2003-01-07]

## Beschreibung

Die Erfindung betrifft eine HF-reduzierende Dachbegrünung nach dem Oberbegriff des Anspruchs 1

Im Zuge des Ausbaus der Mobilfunknetze wächst die Zahl der Feststationen, um einen flächendeckenden Betrieb bei hoher Gesprächskapazität zu ermöglichen. Für den Nutzer von mobilen Endgeräten ist an sich eine hohe Dichte der Feststationen sinnvoll, denn nach den Mobilfunk-Spezifikationen wird das Endgerät veranlasst, nur mit der für eine einwandfreie Funkverbindung nötigen Sendeleistung zu senden. Die Sendeleistung des mobilen Endgerätes wird daher automatisch reduziert, wenn nur eine geringe Entfernung zur Feststation zu überbrücken ist, und damit sinkt auch die Strahlenbelastung für den Benutzer des mobilen Endgerätes.

Um innerhalb von Gebäuden die Belastung durch von den Feststationen ausgehender hochfrequenter elektromagnetischer Strahlung zu reduzieren, sind Abschirmmaßnahmen sinnvoll. Ausgehend von der Überlegung, dass die Strahlenbelastung mit zunehmender Nähe zur Sendeantenne der Feststation zunimmt und die Antennen stets auf einem Höhenniveau oberhalb von Gebäuden angeordnet sind, erweisen sich Dächer von Gebäuden als besonders effektiv für die Durchführung von Abschirmmaßnahmen.

In einer Studie der Universität Gesamthochschule Kassel, die im Juni 2001 in einer Pressemitteilung 60/01 veröffentlicht wurde, wurde herausgefunden, dass Lehmtonnengewölbe mit Grasdach ausgezeichnete Dämpfungseigenschaften für die relevanten Frequenzbereiche des Mobilfunknetzes aufweisen. Dabei nimmt die Dämpfungswirkung mit zunehmender Frequenz zu.

Die Studie gibt ferner Auskunft, dass ein Lehmtonnengewölbe mit Grasdach bei etwa 15 cm Leichtsubstrat eine Durchgangsdämpfung von ca. 49 dB erreicht, während ein Grasdach als solches immerhin ca. 22 dB Strahlungsdämpfung erreicht. Demgegenüber führt ein konventionelles Ziegeldach nur zu einer Strahlungsdämpfung von ca. 3 dB. Aus der Studie sind keine Prognosen möglich, ob die für ein Lehmgewölbe mit Grasdach festgestellten Dämpfungseigenschaften für hochfrequente elektromagnetische Strahlung sich ohne weiteres auch auf eine Dachbegrünung übertragen lassen, die aus einer Trägerkonstruktion aus einer textilen Faserschicht und/oder einem Substrat besteht, auf der eine Vegetationsschicht aus niederen Pflanzen angeordnet ist.

Der Erfindung liegt die Aufgabe zugrunde, eine Dachbegrünung mit einer textilen Faserschicht und/oder einem Substrat, auf der eine Vegetationsschicht aus niederen Pflanzen angeordnet ist, zu schaffen, die erhöhte hochfrequente elektromagnetische Strahlung absorbierende Eigenschaften aufweist.

Diese Aufgabe wird mit den Merkmalen des Anspruchs 1 gelöst.

Die abschirmende Wirkung der elektrisch leitenden Fäden beruht darauf, dass ein Teil der elektromagnetischen Strahlung reflektiert und ein weiterer Teil der elektromagnetischen Strahlung durch Wirbelstromverluste absorbiert wird. Durch die im Vergleich zur Wellenlänge der elektromagnetischen Strahlung geringen Zwischenräume gelangt nur ein geringer Teil der elektromagnetischen Strahlung durch das flächige oder räumliche Gebilde aus elektrisch leitenden Fäden hindurch. Dabei wird die Funktion der Trägerkonstruktion als Träger der Vegetationsschicht nicht beeinträchtigt.

Einen weiteren erheblichen Beitrag zur HF-Reduzierung liefern die textile Faserschicht und/oder das Substrat sowie die Vegetationsschicht aus niederen Pflanzen. Die Dämpfungswirkung ist größer als die Summe der Dämpfungsanteile des flächigen oder räumlichen Gebildes aus elektrisch leitenden Fäden und der textilen Faserschicht und/oder des Substrats sowie der Vegetationsschicht aus niederen Pflanzen für sich. Die beobachtete Synergie beruht vermutlich darauf, dass die von den elektrisch leitenden Fäden abgegebene Sekundärstrahlung durch die unmittelbar benachbarte textile Faserschicht und/oder das Substrat sowie die Vegetationsschicht aus niederen Pflanzen zum Teil absorbiert wird.

Vorzugsweise sind die einzelnen elektrisch leitenden Fäden auch untereinander elektrisch leitend verbunden.

Dadurch ergibt sich eine annähernd durchgehende leitende Fläche.

Das Gebilde aus elektrisch leitenden Fäden kann eine zusätzliche Schicht bilden oder in die Trägerkonstruktion integriert sein.

Je nach Aufbau der Trägerkonstruktion ist es so möglich, das Gebilde aus elektrisch leitenden Fäden ohne Beeinträchtigung der Vegetation mit der Trägerkonstruktion zu kombinieren. Bei einer Integrierung kann das Gebilde aus elektrisch leitenden Fäden auch einzelne Komponenten der Trägerkonstruktion ersetzten oder ergänzen und dadurch den für dieselbe Aufgabe bisher verwendeten Anteil von Fasern oder Fäden nicht leitendem Materials vollständig oder teilweise übernehmen. Der bisherige Anteil an elektrisch nicht leitendem Material kann entsprechend reduziert werden.

Bei dem Gebilde aus elektrisch leitenden Fäden kann es sich um ein Schlingengebilde, eine Matte oder auch um Nahtmaterial handeln, mit dem mehrere Schichten der Trägerkonstruktion untereinander verbunden werden.

Das Gebilde aus elektrisch leitenden Fäden kann als Gitter, Gewebe, Gewirke, Gestricke oder Vlies ausgebildet sein.

Die elektrisch leitenden Fäden können dabei auch die Gestalt von Streifen aufweisen.

Diese Ausgestaltungen erleichtern die Integration des Gebildes aus elektrisch leitenden Fäden in die Trägerkonstruktion ohne Beeinträchtigung der Vegetationsschicht.

Der Abstand zwischen benachbarten elektrisch leitenden Fäden beträgt vorzugsweise zwischen 0,5 mm und 10 mm, je nach Frequenzbereich, der abgeschirmt werden soll.

Bei diesen geringen Abständen der elektrisch leitenden Fäden wirkt das flächige oder räumliche Gebilde bezogen auf die Wellenlänge der elektromagnetischen Strahlung annähern als durchgehend leitende Schicht.

Als Material für die elektrisch leitenden Fäden oder deren Beschichtung kommen Metalle, wie Silber, Kupfer, Zinn, Zink, Aluminium, Nickel, Metalllegierungen, wie Edelstahl oder Kohlefasern in Betracht, die gute elektrische Leitfähigkeit aufweisen.

Ferner können die elektrisch leitenden Fäden eine Oberflächenbeschichtung tragen.

Es werden bevorzugt solche Metalle oder Metalllegierungen eingesetzt, die entweder selbst für die Vegetationsschicht ungiftig sind, oder aber Metalle oder Metalllegierungen, die zur Vermeidung freiwerdender Ionen, Atome, Moleküle oder chemische Verbindungen, die eine Gefahr für das Pflanzenwachstum darstellen, mit einer für die Pflanzen neutralen Beschichtung überzogen sind.

Ein weiteres Kriterium für die Auswahl der Metalle oder Metalllegierungen und die Beschichtungen sind Schwerentflammbarkeit sowie feuerhemmende Eigenschaften.

Nachfolgend wird an Ausführungsbeispielen für die Trägerkonstruktion von Dachbegrünungen die Erfindung näher erläutert.

In der Zeichnung zeigen:
- Fig. 1: einen Schnitt durch eine erste Ausführung einer Dachbegrünung nach der Erfindung und
- Fig. 2: einen Schnitt durch eine zweite Ausführung Dachbegrünung nach der Erfindung.

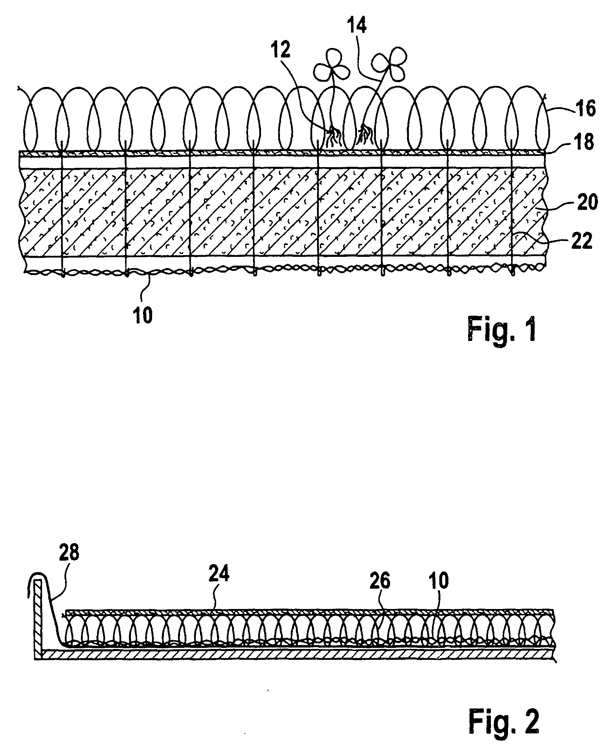

Fig. 1 zeigt eine Trägerkonstruktion für eine Dachbegrünung in Gestalt einer vorkultivierbaren Trägermatte, bei der eine untere Schicht aus einem dicken Vlies 20 und eine obere Schicht aus einem Schlinggewebe 16 bestehen, das seinerseits unten mit einer Vlieskaschierung 18 versehen ist. Das Schlinggewebe 16 mit der Vlieskaschierung 18 ist mit dem dicken Vlies 20 über Verbindungsfäden 22 versteppt. Das Schlinggewebe 16 dient dazu, eine Substratschicht 12 mechanisch zu fixieren, die ihrerseits die Wurzeln einer Vegetationsschicht 14 aufnimmt. Ein Gebilde aus elektrisch leitenden Fäden 10 kann unterhalb, innerhalb oder oberhalb der dicken Vliesschicht 20 angeordnet sein.

Ferner besteht die Möglichkeit, die Vlieskaschierung 18 des Schlinggewebes 16 mit dem Gebilde aus elektrisch leitenden Fäden 10 zu versetzen oder diese Vlieskaschierung 18 selbst daraus zu bilden. Auch besteht die Möglichkeit, das Schlinggewebe 16 durch elektrisch leitende Fäden 10 zu ergänzen oder zu ersetzen. Schließlich ist es auch möglich, die zum Versteppen benötigten Fäden 22 durch die elektrisch leitenden Fäden 10 zu ergänzen oder zu ersetzen.

Soweit das Gebilde aus elektrisch leitenden Fäden 10 in die Trägerkonstruktion integriert oder deren Bestandteil ist, wird die Vegetationsschicht 14 bereits in dieser Konfiguration vorkultiviert. Für den Fall, dass das Gebilde aus elektrisch leitenden Fäden 10 zusätzlich und unabhängig von der Trägermatte eingesetzt wird, kann dies auch erst beim Einbau der vorkultivierten Trägermatte auf der Baustelle erfolgen.

Eine ähnliche Integration ist möglich, wenn statt der Trägermatten mit einem dicken Vlies 20, Trägermatten verwendet werden, bei denen das Vlies durch gesteppte Kokosmatten, Kokosmatten mit Vlies oder Kokosmatten mit Mineralwolle ersetzt oder ergänzt ist. Entsprechendes gilt auch für Trägermatten, bei denen ein Gitternetz als Verstärkung für Wurzelwachstum vorgesehen ist. Dabei kann das Gebilde aus elektrisch leitenden Fäden 10 das Gitternetz ergänzen oder auch die bisher aus Polyethylen gefertigten Fasern ersetzen.

Fig. 2 zeigt den Aufbau einer wurzelfesten Abdichtungsschicht, die zum Schutz der wasserdichten Dachhaut 28 eines Gebäudes dient. Diese Abdichtungsschicht kann zusätzlich unter der Trägermatte nach Fig. 1 eingebaut werden. Die Abdichtungsschicht kann aus einem Schlinggewebe 26 als Drainage sowie einer oberhalb des Schlinggewebes 26 angeordneten Schicht aus einem Schutz- und Trennvlies 24 bestehen.

Hier kann das Gebilde aus elektrisch leitenden Fäden 10 in das Schlinggewebe 26 oder das Schutz- und Trennvlies 24 integriert werden oder auch sonst nötige Fäden des Gewebes oder des Vlieses ersetzen.

Bei einer zusätzlichen Schicht aus hygroskopischer Mineralwolle besteht auch die Möglichkeit, das Gebilde aus elektrisch leitenden Fäden 10 oberhalb, unterhalb oder innerhalb dieser Schicht anzuordnen.

## Patentansprüche

1. HF-reduzierende Dachbegrünung, bestehend aus einer Trägerkonstruktion aus einer textilen Faserschicht und/oder einem Substrat (12) sowie einer Vegetationsschicht (14) aus niederen Pflanzen, **dadurch gekennzeichnet, dass** die Trägerkonstruktion ein flächiges oder räumliches Gebilde aus elektrisch leitenden Fäden (10) umfasst, wobei die Zwischenräume benachbarter elektrisch leitenden Fäden (10) kleiner als ein Viertel der Wellenlänge der abzuschirmenden elektromagnetischen HF-Strahlung bemessen ist.

2. HF-reduzierende Dachbegrünung nach Anspruch 1, **dadurch gekennzeichnet, dass** die elektrisch leitenden Fäden (10) untereinander verbunden sind.

3. HF-reduzierende Dachbegrünung nach Anspruch 1 oder 2, **dadurch gekennzeichnet, dass** das Gebilde aus elektrisch leitenden Fäden (10) eine zusätzliche Schicht bildet oder in die Trägerkonstruktion integriert ist.

4. HF-reduzierende Dachbegrünung nach einem der Ansprüche 1 bis 3, **dadurch gekennzeichnet, dass** das Gebilde aus elektrisch leitenden Fäden (10) ein Schlingengebilde, eine Matte oder Nahtmaterial zur Verbindung mehrerer Schichten der Trägerkonstruktion ist.

5. HF-reduzierende Dachbegrünung nach einem der Ansprüche 1 bis 4, **dadurch gekennzeichnet, dass** das Gebilde aus elektrisch leitenden Fäden (10) als Gitter, Gewebe, Gewirke, Gestricke oder Vlies ausgebildet ist.

6. HF-reduzierende Dachbegrünung nach einem der Ansprüche 1 bis 5, **dadurch gekennzeichnet, dass** die elektrisch leitenden Fäden (10) als Streifen gestaltet sind.

7. HF-reduzierende Dachbegrünung nach einem der Ansprüche 1 bis 6, **dadurch gekennzeichnet, dass** der Abstand zwischen benachbarten Fäden (10) zwischen 0,5 mm und 10 mm beträgt.

8. HF-reduzierende Dachbegrünung nach einem der Ansprüche 1 bis 7, **dadurch gekennzeichnet, dass** die elektrisch leitenden Fäden (10) aus Metallen, wie Silber, Kupfer, Zinn, Zink, Aluminium, Nickel, aus Metalllegierungen, wie Edelstahl, bestehen oder als Kohlefasern ausgebildet sind.

9. HF-reduzierende Dachbegrünung nach einem der Ansprüche 1 bis 8, **dadurch gekennzeichnet, dass** die elektrisch leitenden Fäden (10) eine Oberflächenbeschichtung tragen.

## Claims

1. RF-reducing roof turfing, comprising a support construction of a fibrous textile layer and/or a substrate (13), as well as a vegetation layer (14) of lower plants, **characterized in that** the support construction comprises a flat or three-dimensional system of electrically conductive filaments (10), the gaps between adjacent electrically conductive filaments (10) being smaller than a quarter of the wavelength of the electromagnetic RF radiation to be shielded.

2. RF-reducing roof turfing according to claim 1, **characterized in that** the electrically conductive filaments (10) are interconnected.

3. RF-reducing roof turfing according to claim 1 or 2, **characterized in that** the system of electrically conducting filaments (10) forms an additional layer or is integrated into the support construction.

4. RF-reducing roof turfing according to one of the claims 1 to 3, **characterized in that** the system of electrically conducting filaments (10) is a loop system, a mat or seam material for connecting several layers of the support construction.

5. RF-reducing roof turfing according to one of the claims 1 to 4, **characterized in that** the system of electrically conducting filaments (10) is a lattice, warp-knitted fabric, weft-knitted fabric, woven fabric or fleece.

6. RF-reducing roof turfing according to one of the claims 1 to 5, **characterized in that** the system of electrically conducting filaments (10) is in the form of strips.

7. RF-reducing roof turfing according to one of the claims 1 to 6, **characterized in that** the distance between adjacent filaments (10) is between 0.5 mm and 10 mm.

8. RF-reducing roof turfing according to one of the claims 1 to 7, **characterized in that** the electrically conductive filaments (10) are made from metals such as silver, copper, tin, zinc, aluminium, nickel, metal alloys such as high-grade steel or are in the form of carbon fibres.

9. RF-reducing roof turfing according to one of the claims 1 to 8, **characterized in that** the electrically conductive filaments (10) carry a surface coating.

## Revendications

1. Gazonnement de toiture réduisant les radiofréquences, comprenant une construction porteuse comportant une couche de fibres textiles et/ou de substrat (12), ainsi qu'une couche de végétation (14) composée de plantes basses, **caractérisé en ce que** la construction porteuse comprend un complexe plan ou tridimensionnel en fils électroconducteurs (10), les espaces intermédiaires entre des fils électroconducteurs (10) voisins étant dimensionnés inférieurs à un quart de la longueur d'onde du rayonnement électromagnétique de radiofréquences contre lequel le blindage est prévu.

2. Gazonnement de toiture réduisant les radiofréquences selon la revendication 1, **caractérisé en ce que** les fils électroconducteurs (10) sont reliés entre eux.

3. Gazonnement de toiture réduisant les radiofréquences selon la revendication 1 ou 2, **caractérisé en ce que** le complexe constitué de fils électroconducteurs (10) forme une couche supplémentaire ou est intégré dans la construction porteuse.

4. Gazonnement de toiture réduisant les hautes fréquences selon l'une des revendications 1 à 3, **caractérisé en ce que** le complexe de fils électroconducteurs (10) est un complexe bouclé, une natte ou une matière pouvant être cousue pour la liaison de plusieurs couches de la construction porteuse.

5. Gazonnement de toiture réduisant les radiofréquences selon l'une des revendications 1 à 4, **caractérisé en ce que** le complexe de fils électroconducteurs (10) est conçu comme une grille, un tissu, un maillage, un tricotage ou un non-tissé.

6. Gazonnement de toiture réduisant les radiofréquences selon l'une des revendications 1 à 5, **caractérisé en ce que** les fils électroconducteurs (10) sont conçus sous forme de bandes.

7. Gazonnement de toiture réduisant les radiofréquences selon l'une des revendications 1 à 7, **caractérisé en ce que** l'écart entre des fils (10) voisins est de 0,5 mm et de 10 mm.

8. Gazonnement de toiture réduisant les radiofréquences selon l'une des revendications 1 à 7, **caractérisé en ce que** les fils électroconducteurs (10) sont conçus en métal, par exemple en argent, cuivre, étain, zinc, aluminium, nickel, en alliages de métaux, tels que l'acier fin, ou sous forme de fibres de carbone.

9. Gazonnement de toiture réduisant les radiofréquences selon l'une des revendications 1 à 8, **caractérisé en ce que** les fils électroconducteurs (10) possèdent un revêtement de surface.
